# EUROPÄISCHE PATENTSCHRIFT

(11) **EP 3 465 556 B1**
(45) Veröffentlichungstag und Bekanntmachung des Hinweises auf die Patenterteilung: **02.12.2026**
(21) Anmeldenummer: 17729805.6
(22) Anmeldetag: 26.05.2017
(51) Int. Cl.: G06N 10/40, G01R 33/12

(54) **VORRICHTUNG ZUR SPEICHERUNG ODER MANIPULATION VON QUANTENINFORMATIONEN VERSCHRÄNKTER TEILCHEN**
APPARATUS FOR STORING OR MANIPULATING QUANTUM INFORMATION OF ENTANGLED PARTICLES
DISPOSITIF POUR LA SAUVEGARDE OU LE TRAITEMENT DE L'INFORMATION QUANTIQUE DES PARTICULES INTRIQUEES

(30) Priorität: 27.05.2016 DE 102016109828
(43) Veröffentlichungstag der Anmeldung: 10.04.2019
(73) Patentinhaber: Jacoby, Prof. Dr. Heinz Joachim, 55296 Lörzweiler (DE); Jacoby, Dorothea Hedwig Agnes, 55296 Lörzweiler (DE)
(72) Erfinder: Jacoby, Prof. Dr. Heinz Joachim, 55296 Lörzweiler (DE); Jacoby, Dorothea Hedwig Agnes, 55296 Lörzweiler (DE)
(74) Vertreter: Blumbach · Zinngrebe Patentanwälte PartG mbB
(86) Internationale Anmeldenummer: PCT/EP2017/062770
(87) Internationale Veröffentlichungsnummer: WO 2017/203035

(56) Entgegenhaltungen:
- RUSTAM BEREZOV: "Investigation to observe spin entanglement from elastic scattering of electrons", 3 August 2010 (2010-08-03), Universitätsbibliothek Johann Christian Senckenberg, pages 1 - 125, XP055398730, Retrieved from the Internet <URL:https://www.uni-frankfurt.de/49293314/Dissertationfrankfurt_RustamBerezov.pdf> [retrieved on 20170815]
- BEREZOV R ET AL: "Spin coincidence measurements for a symmetric scattering of electrons with electrons", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NL, vol. 621, no. 1-3, 1 September 2010 (2010-09-01), pages 673 - 677, XP027168634, ISSN: 0168-9002, [retrieved on 20100722]

## Beschreibung

### Gebiet der Erfindung

Die Erfindung betrifft eine Vorrichtung zur Speicherung und/oder Manipulation von Quanteninformationen verschränkter Teilchen.

### Hintergrund und allgemeine Beschreibung der Erfindung

Die Erzeugung und Manipulation von Quanteninformation erlangt besonders in letzter Zeit eine zunehmende Bedeutung. Mögliche Anwendungen davon finden sich zum Beispiel bei der Datenverarbeitung und bei der Informationsübertragung.

Es werden hierbei unterschiedliche Ansätze erforscht, wie Quanteninformationen technisch zugänglich und auswertbar werden. Beispielsweise ist auch in der Forschungsgruppe der Anmelder hierzu Grundlagenarbeit geleistet und veröffentlicht worden, wie in der Dissertation "Investigation to observe spin entanglement from elastic scattering of electrons" des Herrn Dr. Berezov ersichtlich ist.

In der vorliegenden Arbeit, die unter Anderem auf der vorgenannten Dissertation teilweise aufbaut, wird das quantenphysikalische Phänomen der Verschränkung oder der Quantenkorrelation insbesondere von Leptonen bzw. Hadronen ausgenutzt, um Quanteninformation zugänglich zu machen.

Verschränkung liegt vor, wenn der Zustand eines Systems von zwei oder mehr Teilchen sich nicht als Kombination unabhängiger Ein-Teilchen-Zustände beschreiben lässt, sondern nur durch einen gemeinsamen Zustand. Diese Beschreibung ist notwendig nichtlokal, wodurch gegen eine Grundannahme der klassischen Physik verstoßen wird. Lokale Theorien sind hier unzugänglich, da Messergebnisse bestimmter Observablen verschränkter Teilchen (z. B. die Observable des Spins) einerseits korreliert sind, das heißt nicht statistisch unabhängig, auch wenn die Teilchen weit voneinander getrennt sind; andererseits verletzen die Messergebnisse bekanntermaßen die Bellsche Ungleichung.

Infolge der Möglichkeit der Quantenverschränkung bestimmt sich der Gesamtzustand eines zusammengesetzten Systems im Allgemeinen nicht durch die Zustände seiner Teilsysteme, das heißt, er separiert nicht in Teilzustände. Ein verschränkter Zustand kann nicht durch Präparation aller Einzelsysteme in jeweils geeignete Zustände erzeugt werden. Die Verschränkung ist Konsequenz der Superposition der quantenmechanischen Zustandsamplituden: Im Gegensatz zur klassischen Addition von Intensitäten wie in Optik und Elektrodynamik werden in der Quantenmechanik Amplituden und Phasen superponiert, wobei zusätzlich Beimischungen nichtkommutierender Zustände weitere Komplikationen nach sich ziehen können. Für räumlich getrennte Teilsysteme wird Quantenverschränkung zur Quanten-Nichtlokalität, das heißt, der Zustand des verschränkten Systems ist nicht lokalisiert, sondern erstreckt sich über das gesamte räumlich verteilte System.

Die Verschränkung ist auch nicht als rein statistische Korrelation misszuverstehen, was beispielsweise häufig aufgrund der Bornschen Wahrscheinlichkeitsinterpretation der Quantentheorie geschehen ist. Verschränkte Zustände beschreiben individuelle Eigenschaften wie etwa den Gesamtdrehimpuls eines Systems von zwei oder mehr Teilchen.

Da die Verschränkung im Gegensatz zur klassischen Physik keine lokal-realistische Interpretation zulässt, ist entweder die Lokalität aufzugeben, oder das Konzept einer mikroskopischen Realität - oder aber beides. Am radikalsten wird diese Abkehr vom klassischen Realismus in der Kopenhagener Deutung vertreten; nach dieser Interpretation, die seit Jahrzehnten als Standard wahrgenommen wird, ist die Quantenmechanik weder real - da eine Messung den Zustand nicht feststellt, sondern präpariert - noch lokal, weil der Zustandsvektor die Wahrscheinlichkeitsamplitude gleichzeitig an allen Stellen festlegt.

Zwar können verschränkte Systeme auch über große räumliche Entfernung miteinander wechselwirken, dabei kann aber prinzipiell zunächst keine Information übertragen werden, sodass die Kausalität nicht verletzt ist. Dafür gibt es zwei Gründe: Erstens sind quantenmechanische Messungen probabilistisch, d. h. nicht streng kausal. Zweitens verbietet das No-Cloning-Theorem die statistische Überprüfung verschränkter Quantenzustände.

Zwar ist Informationsübertragung durch Verschränkung allein nicht möglich, wohl aber mit mehreren verschränkten Zuständen zusammen mit einem klassischen Informationskanal (Quantenteleportation). Trotz des Namens können wegen des klassischen Informationskanals keine Informationen schneller als das Licht übertragen werden.

Bei Photonen bezieht sich die Verschränkung meist auf die Polarisation der Photonen. Misst man die Polarisation des einen Photons, ist dadurch die Polarisation des anderen Photons festgelegt (z. B. um 180° gedreht).

Bei Atomen bezieht sich die Verschränkung typischerweise auf deren Spin. Regt man ein geeignetes zweiatomiges Molekül mit einem Spin von null beispielsweise mit einem Laser derart hoch an, dass es dissoziiert, sind die beiden freiwerdenden Atome bezüglich ihres Spins verschränkt. Bei einer entsprechenden Messung wird eines von ihnen beispielsweise den Spin +1/2 zeigen, das andere -1/2. Es ist aber nicht vorhersagbar, welches der beiden Atome den positiven und welches den negativen haben wird. Misst man aber den Spin eines der beiden Atome, wird dadurch der Spin des anderen festgelegt.

Wünschenswerte Anwendungen, die heutzutage intensiv erforscht werden, sind beispielsweise der Quantenschlüsselaustausch. Beim Quantenschlüsselaustausch handelt es sich um den sicheren Austausch von Schlüsseln zwischen zwei Kommunikationspartnern zur verschlüsselten Übermittlung von Information. Der Austausch ist vermeintlich sicher, weil es nicht möglich ist, den Austausch ohne Störung abzuhören. Die austauschenden Partner können daher ein "Mithören" beim Schlüsselaustausch bemerken.

Ferner beispielsweise ist auch der Quantencomputer ein wünschenswertes Ziel. Bei Berechnungen mittels Qubits auf einem Quantencomputer könnte bei manchen Algorithmen die Verschränkung von Qubits untereinander genutzt werden. Mit Quantencomputern könnten Probleme gelöst werden, die mit konventionellen Computern zwar prinzipiell lösbar sind, jedoch nur mit nicht realisierbarem Zeitaufwand.

Generell ist die Erzeugung verschränkter Systeme jedoch nicht einfach, weshalb bisher kein praktisch anwendbarer Quantencomputer für komplexe Berechnungen existiert. Die Erzeugung und Ausnutzung verschränkter Systeme ist gegenwärtig noch ein überwiegend theoretisches Konzept.

Eine wenig beachtete Möglichkeit zur Erzeugung von verschränkten Teilchen ist durch die symmetrische Streuung gegeben, bei der zwei Teilchen derselben Teilchensorte (zum Beispiel Leptonen an Leptonen oder Hadronen an Hadronen; d.h. z.B. Elektronen an Elektronen oder Protonen an Protonen) unter weitgehend symmetrischen Bedingungen aneinander streuen. Im Schwerpunktsystem wird der Streuwinkel für beide Streuteilchen dann etwa 90 Grad zueinander betragen. Bei einer so erzeugten Verschränkung wird der Wirkungsquerschnitt für die Streuung durch die nichtlokalen Eigenschaften der Quantenmechanik von der Spinmessung nach der Streuung festgelegt. Zum Beispiel für Fermionen sind dabei gleiche Spinzustände verboten, während gleiche Spinzustände für Bosonen bevorzugt sind.

Im Falle von verschränkten Teilchen liegen daher hier ununterscheidbare Teilchen vor. Der Streuwirkungsquerschnitt von so gestreuten ununterscheidbaren Fermionen ist daher typischerweise kleiner als ohne eine Verschränkung. Ohne Verschränkung sind die Teilchen in diesem Beispiel im Prinzip unterscheidbar.

Für unpolarisierte Elektronen und Protonen wird dabei zum Beispiel der nicht relativistische Streuwirkungsquerschnitt etwa auf die Hälfte des Wertes abgesenkt, der sich ohne diese Bedingung ergeben würde.

Sofern der Wirkungsquerschnitt nicht unmittelbar und direkt einer Messung zugänglich ist, kann beispielsweise eine dem Wirkungsquerschnitt verwandte Messgröße herangezogen werden. Beispielsweise können die Intensitäten der so gestreuten Teilchen ermittelt werden. Eine Intensität von gestreuten Teilchenpaaren kann auch vorteilhaft durch eine Koinzidenzmessung ermittelt werden.

Bei Messungen an den gestreuten Teilchen kann eine frühere Verschränkung der gestreuten Teilchen bereits aufgehoben sein. Der Transport dieser Teilchen kann bevorzugt in einem Vakuum stattfinden.

Als Zwischenergebnis lässt sich festhalten, dass die vorliegende Erfindung es sich zur Aufgabe gemacht hat, eine Vorrichtung zu entwickeln, mittels welcher zunächst verschränkte Teilchen erzeugt werden können, sodann eine Quanteninformation von diesen Teilchen auf ein Übertragungsziel übertragen werden kann. Diese Quanteninformation kann sodann an dem Übertragungsziel gegebenenfalls manipuliert und schließlich die Quanteninformation durch eine Messung charakterisierbar gemacht werden.

Ein weiterer Aspekt der Aufgabe ist, ein Speichermedium bereitzustellen, mittels welchem die Quanteninformation speicherbar ist, wobei das Speichermedium vorzugsweise von dem Erzeugungsort der verschränkten Teilchen entfernt aufstellbar ist und/oder die Speicherdauer eine makroskopische Größe annimmt, d.h. technisch nutzbar ist. Als makroskopische Größe kann beispielsweise eine Zeitdauer von länger einer Mikrosekunde oder länger einer Millisekunde aufgefasst werden. Als makroskopische Größe kann auch eine Zeitdauer von länger als einer Sekunde oder sogar länger als ein Tag Speicherdauer genutzt werden.

Weitere Aufgaben ergeben sich aus der nachfolgenden Beschreibung bzw. den besonderen Vorteilen die mit bestimmten Ausführungsformen erzielt werden.

Die Aufgabe wird durch den Gegenstand der unabhängigen Ansprüche gelöst. Mit anderen Worten ist die Erfindung in dem oder den unabhängigen Patentansprüchen definiert. Vorteilhafte Ausführungsformen sind Gegenstand der abhängigen Ansprüche.

Im Weiteren werden Möglichkeiten erläutert, die mit der Erfindung ermöglicht sind. Dies dient als Hintergrund sowie zum Verständnis der Erfindung, welche ausschließlich in dem bzw. den unabhängigen Patentansprüchen definiert ist.

Eine Idee der Erfindung ist die Nutzung der Abhängigkeit des Wirkungsquerschnittes für die Erzeugung der verschränkten Teilchen bei symmetrischer Streuung von der Messung des Spins nach besagter symmetrischer Streuung. Dazu kann insbesondere die Intensität der so gestreuten Teilchen nachgewiesen werden.

Das erfindungsgemäße Verfahren zur Informationsübertragung mittels Quanten- oder Spininformation umfasst jedenfalls den Schritt Bereitstellen von zumindest einem Paar bestehend aus einem ersten und einem zweiten quantenphysikalisch verschränkten Teilchen. Das Verfahren kann auch hergerichtet sein zur nichtlokalen Informationsübertragung mittels Quanten- oder Spininformation.

Beispielsweise kann das Paar quantenphysikalisch verschränkter Teilchen von einem Target bereitgestellt werden, bzw. allgemein von einer Vorrichtung zur Bereitstellung von quantenphysikalisch verschränkten Teilchen.

Das Verfahren zur Informationsübertragung umfasst ferner den Schritt Erfassen der Quanten- oder Spininformation aus dem ersten verschränkten Teilchen und/oder dem zweiten verschränkten Teilchen mittels elektromagnetischer Wechselwirkung. Dies kann beispielsweise in einem Resonator erfolgen.

Ferner umfasst das Verfahren den Schritt Speichern der Quanten- oder Spininformation des ersten und/oder zweiten verschränkten Teilchens in einem Informationsspeicher. Der Informationsspeicher ist ein Quanteninformationsspeicher oder ein Spininformationsspeicher. In einer Ausführung wird die gespeicherte Quanten- oder Spininformation des ersten verschränkten Teilchens schließlich manipuliert und es erfolgt eine nichtlokale Übertragung der Information auf das zweite quantenphysikalisch verschränkte Teilchen.

Eine räumlich nichtlokale Informationsübertragung ist allerdings nach der "Bell'schen Ungleichung" als unmöglich vorausgesagt, zumindest nicht kausalitätsverletzend. Nicht ausgeschlossen wird jedoch eine zeitlich nichtlokale Informationsübertragung über eine "früher - später" Messung und/oder Manipulation.

Eine Messung würde den Zustand des zweiten Teilchens festlegen, was als Manipulation des zweiten Teilchens aufgefasst werden kann. Wird also die gespeicherte Quanten- oder Spininformation des ersten verschränkten Teilchens manipuliert, erfolgt eine nichtlokale Übertragung der Quanten- oder Spininformation auf das zweite quantenphysikalisch verschränkte Teilchen - oder umgekehrt.

Werden die gespeicherte Quanten- oder Spininformation beider verschränkter Teilchen manipuliert, d.h. die Quanten- oder Spininformation des ersten und des zweiten verschränkten Teilchens, wird die Unterscheidbarkeit bzw. Ununterscheidbarkeit des verschränkten Teilchenpaares manipuliert oder verändert oder beeinflusst, wodurch ein veränderter Wirkungsquerschnitt vorliegt.

Die im Informationsspeicher gespeicherte Quanten- oder Spininformation des ersten und/oder zweiten verschränkten Teilchens wird nunmehr manipuliert, d.h. zum Beispiel gelöscht oder verändert. Gegebenenfalls kann auch die Nichtveränderung der Quanten- oder Spininformation als Manipulation aufgefasst werden. Im Allgemeinen wird die Manipulation der Quanten- oder Spininformation in Abhängigkeit von einer wählbaren Größe, der Kenngröße, durchgeführt. Ein Beispiel für eine Kenngröße, die zur Manipulation der Quanten- oder Spininformation herangezogen werden kann, ist die Koinzidenzrate bzw. das Ergebnis einer Koinzidenzmessung. Mittels der Koinzidenzrate kann die Quanten- oder Spininformation charakterisiert werden. Die Kenngröße stellt eine Verknüpfung einer äußeren Variablen mit der Koinzidenz der verschränkten Teilchen oder mit der Koinzidenzrate her. Die Koinzidenz ist beispielsweise aus dem koinzidenten Nachweis der verschränkten Teilchen erhaltbar. Die äußere Variable kann dabei ein von der Vorrichtung völlig unabhängiges System oder ein unabhängiger Zustand sein. Die äußere Variable wird mittels der Kenngröße mit der Koinzidenz der verschränkten Teilchen verknüpft.

Mit anderen Worten kann die Kenngröße beispielsweise herangezogen werden, zu entscheiden, ob die Quanten- oder Spininformation manipuliert wird oder nicht.

Die Kenngröße kann beispielsweise zwei verschiedene Zustände einnehmen, um somit auf die Manipulation der Spin- oder Quanteninformation einzuwirken. In einem einfachen Beispiel weißt die Kenngröße einen Zustand "1" bzw. "Manipulieren" sowie einen Zustand "2" bzw. "Löschen" auf. Weist die Kenngröße z.B. den Zustand "1" auf, so wird die Vorrichtung so eingestellt, dass die Quanten- oder Spininformation manipuliert wird. Die Kenngröße kann schließlich den jeweiligen Zustand "1" bzw. "2" in Ansprechen auf die äußere Variable einnehmen. Ist die Kenngröße ein Schwellwert, so wird die Kenngröße den Wert "1" beispielsweise bei Überschreiten des Schwellwerts einnehmen.

Mittels der Manipulation der Quanten- oder Spininformation des ersten verschränkten Teilchens wird eine nichtlokale Übertragung der Information auf das zweite quantenphysikalisch verschränkte Teilchen induziert und umgekehrt. Bei einer Quantenlöschung können schließlich beide Teilchen, d.h. das erste und das zweite verschränkte Teilchen, manipuliert werden.

Insbesondere kann bei dem Verfahren eine Intensität oder eine Anzahl von verschränkten Teilchen bestimmt werden.

Die erfindungsgemäße Vorrichtung zur Übertragung und/oder Manipulation einer Information, die in einem System aus zumindest zwei quantenphysikalisch verschränkten Teilchen enthalten ist, umfasst eine Begrenzung zur Einschränkung der Ausbreitung von elektromagnetischer Strahlung der Teilchen. Die Begrenzung wird insbesondere durch ein gut leitendes Material ausgebildet und schränkt die elektromagnetische Strahlung in der Vorrichtung dergestalt ein, dass die Strahlung, zumindest im ganz Wesentlichen, in der Apparatur verbleibt.

Mit anderen Worten bildet die Begrenzung also im Wesentlichen einen elektromagnetischen Resonator, insbesondere einen Hohlraumresonator. Besonders vorteilhaft steht die Resonatoreigenschaft der Begrenzung während einer Informationsübertragung von den verschränkten Teilchen zur Verfügung.

Die Vorrichtung weist ferner eine Messeinrichtung zur Bestimmung einer Intensität oder einer Anzahl verschränkter Teilchen auf. Typischerweise lässt sich nicht ein einzelnes Teilchenpaar allein detektieren, so dass auf eine statistisch relevante Anzahl Teilchen zurückgegriffen werden kann, um eine statistisch relevante Größe zu bestimmen.

Ferner weist die erfindungsgemäße Vorrichtung eine Erfassungseinrichtung zum Empfangen bzw. zum Übertragen der Spininformation aus zumindest einem der verschränkten Teilchen mittels elektromagnetischer Wechselwirkung auf.

Eine Manipulationseinrichtung ist vorgesehen zur Manipulation der mit der Erfassungseinrichtung empfangenen Spininformation. Die Manipulationseinrichtung kann beispielsweise dazu hergerichtet sein, die Manipulation der Spininformation durch eine selektive Anregung der betroffenen Quantenzustände durchzuführen. Hierfür kann die Erfassungseinrichtung einen geeigneten Felderzeuger zur Bereitstellung eines Wechselfeldes aufweisen.

Eine in Speichermedium-Elektronen gespeicherte Spininformationen kann unter Kopplung an einen Resonator an- oder abgeregt werden. Dies stellt ein Beispiel dar dafür, dass die Messung der Spininformation mit dem Speichermedium manipulierbar ausgebildet werden kann. Die Manipulationseinrichtung kann ferner dazu hergerichtet sein, die Manipulation der Spininformation durch ein wählbares Messen von orthogonalen Quantenzuständen der Spininformation durchzuführen.

Eine anteilige Bestimmung der Verschränkung der Teilchen kann in vorteilhafter Weise zusammen mit einer Übertragung von Spininformation von einigen der verschränkten Teilchen auf das Speichermedium durchgeführt werden.

Die wahlweise Manipulation der gespeicherten Spininformation kann ferner an einem anderen Ort erfolgen als die Übertragung von Spininformation von den verschränkten Teilchen.

Bevorzugt kann die Erfassungseinrichtung Mittel aufweisen zum Bereitstellen eines elektrischen oder magnetischen Felds für die Übertragung der Spininformation, insbesondere für den Zeitpunkt oder den Ort der Übertragung der Spininformation auf das Speichermedium.

Insbesondere bestehen die Teilchen zur Informationsübermittelung und die Teilchen des Speichermedium aus den gleichen Teilchenarten. Die Verwendung gleicher Teilchenarten bei den verschränkten Teilchen und den Speichermedium-Teilchen vereinfacht die Auswertung der Spininformation.

Bei den Speichermedium-Teilchen kann direkt oder indirekt, ganz oder teilweise mindestens ein Quantenzustand geändert werden. Mit anderen Worten wird durch die Übertragung der Information von den verschränkten Teilchen auf die Speichermedium-Teilchen direkt oder indirekt, ganz oder teilweise ein Quantenzustand des Speichermedium-Teilchens modifiziert. Die Vorrichtung kann ferner eine Strahlungsquelle zum Erzeugen von Primärteilchen aufweisen. Als Primärteilchen werden bevorzugt die gleichen Teilchenarten eingesetzt wie für die verschränkten Teilchen. Die Strahlungsquelle kann ferner derart eingestellt sein, dass die Primärteilchen als Strahl aus der Strahlungsquelle austreten, mit anderen Worten also ein Teilchenstrahl aus Primärteilchen bereitgestellt wird. Mit anderen Worten erzeugt die Vorrichtung bevorzugt zunächst Primärteilchen, wobei die Primärteilchen wiederum insbesondere durch eine physikalische Reaktion die Streuteilchen erzeugen. Die physikalische Reaktion kann zum Beispiel aus dem Beschuss eines Streutargets mit den Primärteilchen resultieren, wobei die im Streutarget ablaufenden (physikalischen bzw. ggf. chemischen) Prozesse die physikalische Reaktion darstellen.

Die Vorrichtung umfasst daher bevorzugt ein Streutarget. Wenn die Strahlungsquelle auf das Streutarget gerichtet wird, also mit anderen Worten der Teilchenstrahl aus Primärteilchen auf das Streutarget gerichtet ist, wird das Streutarget mit den Primärteilchen beschickt. Beim Auftreffen der Primärteilchen auf das Streutarget können verschränkte Teilchen durch eine Wechselwirkung der Primärteilchen mit dem Streutarget erzeugt werden.

Die Vorrichtung kann bevorzugt eine Transportstrecke zum Transport der verschränkten Teilchen zu einem Endflansch aufweisen. Die Transportstrecke ist bevorzugt gasdicht ausgeführt, wobei in der Transportstrecke ferner bevorzugt ein Vakuum aufgebaut ist, so dass die Transportstrecke für die verschränkten Teilchen auf ihrem Transportweg, insbesondere von dem Streutarget zu dem Speichermedium und/oder zu der Messeinrichtung, eine möglichst hohe Transmission bereitstellt.

An dem Endflansch sind weiter bevorzugt Szintillatoren angeordnet zur Erzeugung eines Messsignals zur Auswertung der verschränkten Teilchen.

Die Vorrichtung kann ferner eine Anregungseinrichtung aufweisen, insbesondere umfassend einstellbare Elektromagnetspulen zur Erzeugung eines Magnetfelds. Mit der Anregungseinrichtung kann bevorzugt ein Quantenniveau im Speichermedium festgelegt werden. Mit anderen Worten kann mit der Anregungseinrichtung eine Beeinflussung der Speichermedium-Teilchen angebracht werden.

Die Begrenzung kann ferner insbesondere als Resonator ausgeführt sein. Die Anregungseinrichtung kann in diesem Fall besonders bevorzugt an den Resonator gekoppelt sein.

Die Zeitdauer bis zum Zerfallen der Speicherinformation begrenzt typischerweise auch die Speicherdauer. Beispielsweise für polarisiertes He-3-Gas sind hierbei Speicherzeiten von einigen Tagen realisierbar.

Zusätzlich zu einer oder zu mehreren Intensitätsmessungen der verschränkten Teilchen wird vorgeschlagen, eine oder mehrere Wechselwirkungsregionen in der Vorrichtung vorzusehen, wo vorzugsweise durch elektrische oder magnetische Felder Wechselwirkungen mit den gestreuten Teilchen - d.h. mit den verschränkten Teilchen - stattfinden. Diese Wechselwirkungen können auch in direkter Nähe zu dem Ort der Erzeugung der verschränkten Teilchen - d.h. insbesondere in der Nähe des Streutargets - stattfinden. Typisch wird in diesen Wechselwirkungsregionen ein natürliches oder ein durch die Wechselwirkung erzeugtes magnetisches Feld bereitgestellt, das schwach sein kann. Der Spin der gestreuten Teilchen wird sich dann durch dieses magnetische Feld in einem definierten Energiezustand befinden, der teilweise unter Einwirkung der in der Wechselwirkungsregion wirkenden Kräfte zu einer Emission oder Absorption angeregt wird.

Ferner wird im Rahmen der vorliegenden Arbeit vorgeschlagen, die elektromagnetische Strahlung in der Apparatur - d.h. die Strahlung der verschränkten Teilchen - durch die typisch gut leitende Begrenzung so einzuschränken, dass die elektromagnetische Strahlung in der Apparatur verbleibt. Mit anderen Worten ist die Apparatur derart gestaltet, dass die Strahlung die Apparatur nicht ungewünscht verlassen kann, wodurch quasi ein elektromagnetischer Resonator gebildet wird.

Wenn sich also nun in der Nähe der oder sogar direkt in den Wechselwirkungsgebieten bevorzugt ein Speichermedium befindet, auf das der Spinzustand der gestreuten Teilchen übertragen werden kann, so wird diese Möglichkeit der Spinmessung den Streuwirkungsquerschnitt erhöhen bis der maximale theoretische Gesamtwert erreicht ist. Bis zu einer kleinen Zahl an gleichzeitig angeregten Übergängen ist es auch möglich, die elektromagnetische Strahlung zunächst direkt im elektromagnetischen Resonator zu speichern, um möglicherweise später diese zunächst auf den Resonator übertragene Strahlung auf ein anderes Speichermedium zu übertragen.

Wenn das Speichermedium einem geeigneten Wechselfeld der Anregungseinrichtung ausgesetzt wird, das die gespeicherten Spinübergänge unter Kopplung an einen Resonator an- oder abregen kann, so kann damit die Messung der Spinzustände mit dem Speichermedium manipuliert werden.

Das Anlegen des an einen Resonator gekoppelten Wechselfeldes der Anregungseinrichtung - wobei es sich typisch um ein Hochfrequenzfeld handelt - führt daher zu einer nichtlokalen Änderung des Messsignals. Durch den Austausch des Speichermediums oder durch das Zerfallen oder durch ein Messen der Speicherinformation im Medium kann insgesamt die Apparatur in einen Ausgangszustand wie vor Beginn der Übertragung zurückgesetzt werden. Mit anderen Worten ist das Speichermedium hernach erneut bereit zur Aufnahme einer Information aus verschränkten Teilchen.

Das Messen oder Zerfallen von Speicherinformation bedeutet dabei insbesondere eine Übertragung der Spininformation auf andere Quantenzustände in einem Resonator. Weiter bevorzugt ist der Resonator dabei ein Resonator mit niedriger Güte. Durch eine Wiederholung der Prozesse kann dann weitere Information übertragen und manipuliert werden. Die Zeitdauer bis zum Zerfallen der Speicherinformation im Medium kann dann die Übertragungszeit dieser Information begrenzen. Dabei sind zum Beispiel für polarisiertes 3He-Gas Speicherzeiten von einigen Tagen möglich.

Eine Verschränkung über den Spin zweier Teilchen ist dadurch gekennzeichnet, dass eine Wahlmöglichkeit besteht, welche Spinkoordinatenrichtung (zum Beispiel horizontal, vertikal, longitudinal) gemessen werden soll. Es kann dann bei der Messung eines Spins eine Aussage über die Spinausrichtung des zweiten gestreuten Teilchens für dieselbe Koordinatenachse gemacht werden. Für zueinander senkrecht stehende also orthogonale Koordinatenachsen kann eine Aussage über die Spinrichtung des zweiten gestreuten Teilchens nicht gemacht werden. Für Elektronen- oder Protonenpaare ist dann bei einer durch symmetrische Streuung erzeugten Verschränkung, bezogen auf eine Koordinatenachse, eine unterschiedliche Spinausrichtung der Einzelteilchen nachweisbar. Durch endgültige Übertragung dieser Spininformation auf ein Speichermedium wird diese Verschränkung aufgehoben. Der Nachweis der Verschränkung, beziehungsweise die Messung der Nicht-Verschränkung enthält also Information darüber, welche Spininformation auf das Speichermedium übertragen worden ist.

Diese Vorrichtung zur Übertragung und Manipulation von Quanteninformation aus verschränkten Teilchen mit Ladung und Spin kann dann eine Intensitätsmessung oder eine Messung der anteiligen Verschränkung der Teilchen aufweisen. Zudem kann die Manipulation der Spininformation im Medium und vorzugsweise ein Austausch oder eine Messung der Informationsträger des Speichermediums in der Vorrichtung ermöglicht sein. Mittels des Austausches oder der Messung der Informationsträger des Speichermediums in der Vorrichtung kann eine Rücksetzung der Vorrichtung in einen Anfangszustand erfolgen.

Dazu wird im Weiteren dargelegt, einen Strahl aus mindestens einem Teil der verschränkten Teilchen - nicht notwendigerweise bei getrennten Paaren - innerhalb eines oder mehrerer Magnetfelder zu bringen, wo auf die Teilchen zeitweise Kräfte ausgeübt werden. Falls in der Apparatur ein äußeres Magnetfeld - beispielsweise das der Anregungseinrichtung - verwendet wird, so kann das Magnetfeld durch eine oder mehrere Spulen, durch die elektrischer Strom fließt, erzeugt werden. Eine Anordnung von Permanentmagneten, oder eine Kombination von Spule und magnetischem Material ist ebenfalls zur Erzeugung eines Magnetfelds zweckmäßig. Es kann vorteilhaft sein, in verschiedenen Bereichen der Apparatur unterschiedliche Feldrichtungen für das magnetische Feld zu verwenden. Es wird weiter vorgeschlagen, dass sich in der Nähe nun weitere Teilchen mit Spin befinden, durch die das Speichermedium durch Kopplung an den Resonator gebildet wird. Es kann sich bei diesen weiteren Teilchen besonders bevorzugt auch um die gleiche Teilchensorte handeln, die bereits zur Bildung des Strahls aus mindestens einem Teil der verschränkten Teilchen verwendet wird.

Ein Austausch der Elektronen oder Ionen des Speichermediums kann dabei beispielsweise durch das Anlegen von elektrischen Feldern erreicht werden, wodurch die Elektronen oder Ionen zumindest teilweise wieder entfernt werden können.

Bei Flüssigkeiten oder Gasen als Speichermedium kann ein Austausch mit Hilfe eines geeigneten Rohrsystems zum Speichermedium erfolgen.

Bei einem Austausch des Speichermediums ist die Manipulation der Spininformation direkt am Ort der Quantenübertragung oder mit einer externen Vorrichtung möglich. Eine Informationsspeicherung der Spininformation und damit auch ihre Manipulation ist in einem bevorzugten Ausführungsbeispiel ohne externes Magnetfeld möglich, wenn als Informationsspeicher besondere Hyperfeinübergänge verwendet werden, wie sie besonders bei Atomen aus der ersten Hauptgruppe des Periodensystems vorhanden sind.

Wenn als Resonator zur Manipulation der Quanteninformation ein elektromagnetischer Schwingkreis verwendet wird, kann sich das Speichermedium innerhalb einer Zylinderspule mit geeigneter Induktivität befinden. Die Anregung der Zylinderspule kann bei der passenden Frequenz für die Spinübergänge mit Hilfe eines Frequenzgenerators erfolgen.

Wenn es eine Übertragung von Spininformation aus dem zuerst zur Spinspeicherung genutzten Spinübergang auf weitere Quantenzustände gegeben hat, kann es sinnvoll sein, auch diese Quantenübergänge zu manipulieren, wozu dann andere Frequenzen erforderlich sein können.

Aufgabe der vorgeschlagenen Vorrichtung ist es zusammenfassend, verschränkte Teilchen zu erzeugen, Quanteninformation von diesen Teilchen auf ein Speichermedium zu übertragen, dort gegebenenfalls zu manipulieren und diese Quanteninformation durch eine Messung zu charakterisieren.

Die Vorrichtung weist die besonderen Merkmale und Ausgestaltungen auf, eine Möglichkeit zur Messung der erzeugten Teilchen mit oder ohne direkten Nachweis der Verschränkung zu bieten, die Übertragung von Spininformation auf ein Speichermedium in einem Resonator, die wahlweise Möglichkeit zur Manipulation der Spininformation beispielsweise durch das Anlegen von Hochfrequenz und vorzugsweise einer Möglichkeit zum Austausch der Informationsträger im Speichermedium.

Die Speicherung und Manipulation von Quanteninformation für Sekunden oder länger hat mögliche Anwendungen zum Beispiel bei der Datenverarbeitung und bei der Informationsübertragung.

Ferner erfindungsgemäß ist ein Quantencomputer, der mit einer Vorrichtung zur Übertragung und Manipulation einer Information ausgerüstet ist, zur Manipulation und Speicherung von Quantenbitzuständen.

Auch ein System zur Informationsübertragung in die Vergangenheit ist erfindungsgemäß, umfassend eine Vorrichtung zur Übertragung und/oder Manipulation einer Information, die in einem System aus zumindest zwei quantenphysikalisch verschränkten Teilchen enthalten ist. Die Vorrichtung zur Übertragung und/oder Manipulation einer Information umfasst eine Begrenzung zur Einschränkung der Ausbreitung von elektromagnetischer Strahlung der Teilchen, insbesondere während einer Informationsübertragung, eine Messeinrichtung zur Bestimmung einer Intensität oder einer Anzahl verschränkter Teilchen oder einer Koinzidenz, eine Erfassungseinrichtung zum Empfangen der Spininformation aus zumindest einem der verschränkten Teilchen mittels elektromagnetischer Wechselwirkung, eine Manipulationseinrichtung zur Manipulation der mit der Erfassungseinrichtung empfangenen Spininformation. Die in den quantenphysikalisch verschränkten Teilchen enthaltene Information wird hierbei rückwirkend durch die Manipulation der empfangenen Spininformation festgelegt sowie hierdurch eine Information in die Vergangenheit übertragen.

Schließlich ist ein Entschlüsselungssystem zur Dekodierung von Verschlüsselungssystemen vorgestellt, beispielsweise zur Dekodierung von asymmetrischen Verschlüsselungsverfahren.

Im Folgenden wird die Erfindung anhand von Ausführungsbeispielen und unter Bezugnahme auf die Figuren näher erläutert, wobei gleiche und ähnliche Elemente teilweise mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine Skizze eines Messaufbaus zur Messung verschränkter Teilchen,
- Fig. 2: eine Skizze eines weiteren Messaufbaus zur Messung verschränkter Teilchen,
- Fig. 3: ein Verfahrensablaufdiagramm,
- Fig. 4: Draufsicht auf einen Endflansch eines experimentellen Aufbaus,
- Fig. 5: weitere Ansicht eines experimentellen Aufbaus,
- Fig. 6: Aufbau eines Speichermediums,
- Fig. 7: weitere Ausführungsform eines Speichermediums.

### Detaillierte Beschreibung der Erfindung

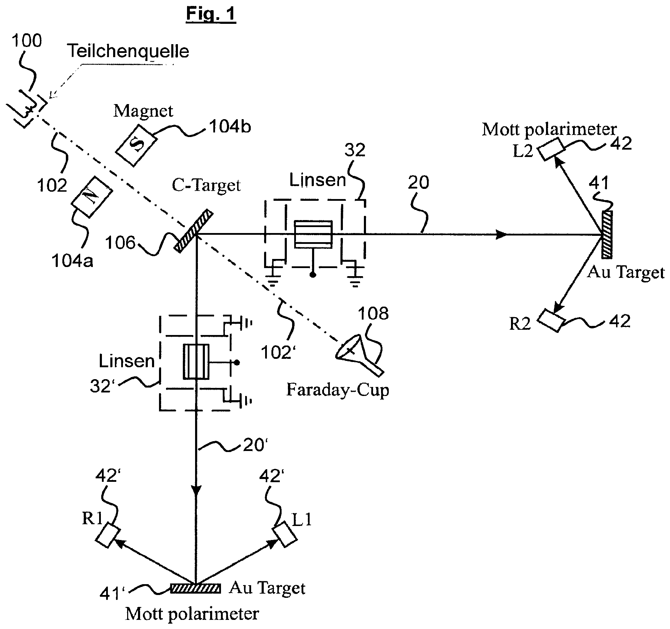

Fig. 1 zeigt einen schematischen Aufbau zur Messung verschränkter Teilchen 20. Mit einer Elektronenkanone 100 wird ein Strahl aus Primärteilchen 102 erzeugt. Die Position des Strahls 102 wird in diesem Beispiel mittels Primärstrahl-Magnete 104a, 104b eingestellt und auf ein Streutarget 106, hier ein Kohlenstoff-Target 106, gerichtet. Das Streutarget 106 weist eine Flächendichte von einigen µg/cm² auf, beispielsweise im Bereich von 3 bis 8 µg/cm² oder im Bereich von 3 bis 6 µg/cm². Mit anderen Worten weist das in diesem Beispiel verwendete Streutarget 106 eine Flächendichte von 3 µg/cm² oder mehr auf und/oder weist eine Flächendichte von 8 µg/cm² oder weniger auf.

Die das Streutarget 106 ohne Streuung durchdringenden Primärteilchen 102' werden von einer Faraday-Cup 108 aufgefangen. Mittels des Faraday-Cups 108 kann zugleich eine Intensitätsmessung des Primärstrahls 102 durchgeführt werden.

Gestreute Elektronen mit verschränkten Teilchen 20 werden in diesem Beispiel unter einem Winkel von ungefähr 45° gestreut, und mittels Einzel-Linsen 32 zu einem Streustrahl 20 in Richtung des Detektors 40 fokussiert. In diesem Beispiel ist ein Mott-Polarimeter 40 eingesetzt. Hierin werden die Teilchen 20 an einer Goldfolie 41 gestreut, beispielsweise mit einer Flächendichte von ungefähr 70 µg/cm², und von weiteren Detektoren 42 Koinzidenzmessungen durchgeführt.

Weitere gestreute Teilchen, nämlich die, die unter einem Winkel von 90° zu den gestreuten Teilchen aus dem Streutarget 106 austreten, werden von weiteren Einzel-Linsen 32' zu einem weiteren Streustrahl 20' in Richtung des Detektors 40' mit Goldfolie 41' und weiteren Detektoren 42' fokussiert.

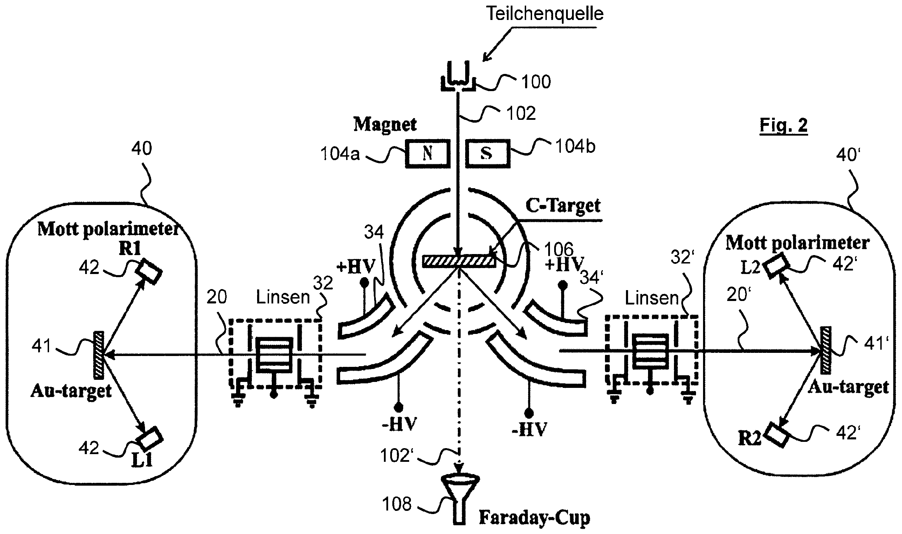

Fig. 2 zeigt einen weiteren schematischen Aufbau zur Messung verschränkter Teilchen 20. Der von einer Elektronenkanone 100 erzeugte Primärstrahl 102 ist auf ein Streutarget 106 gerichtet. Die Targetdicke des Streutargets 106 beträgt in einem Beispiel 100 nm. Die Messung der Intensität des Primärstrahls 102 übernimmt eine Faraday-Cup 108. Anstelle des Faraday-Cup 108 kann auch ein Elektronen-Multiplier 108 eingesetzt sein.

Gestreute Teilchen 20 werden nach dem Streutarget 106 zunächst in einem elektrostatischen Ablenkfeld 34 abgelenkt. Bei dieser Ablenkung können niederenergetische Möller-Streuteilchen (Elektron-Elektron-Streuung) von höherenergetischen Mott-Streuteilchen (Elektron-Kern-Streuung) getrennt werden. Der Strahl mit den verschränkten Teilchen 20 wird hernach von Einzel-Linsen 32 fokussiert und dem Mott-Polarimeter 40 zugeführt. Das Mott-Polarimeter weist eine Messgerät-Target 41 sowie weitere Detektoren 42 auf.

Auch in diesem Beispiel wird ein weiterer Strahl aus verschränkten Teilchen 20' mittels Einzel-Linsen 32' fokussiert und dem Detektor 40' zugeführt.

Das Streutarget 106 kann in einem Beispiel ein Heliumgastarget sein, wobei die Primärteilchen 102 He+ umfassen, die an dem He gestreut werden. Das Messgerät-Target 41 kann im Falle des Einsatzes von Elektronen z.B. eine Goldfolie sein.

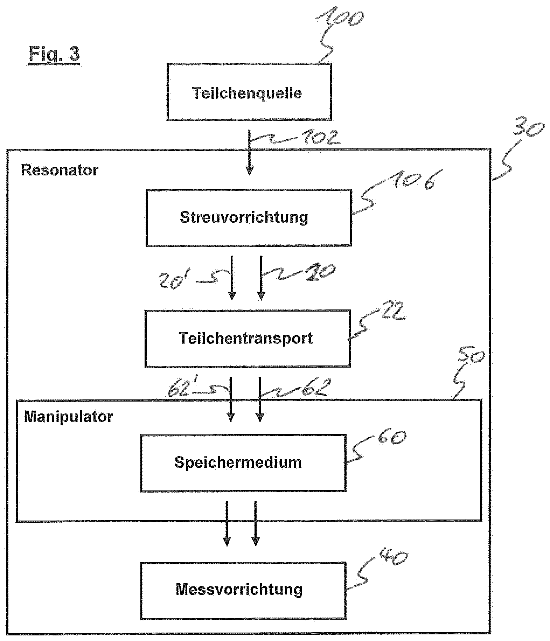

Fig. 3 zeigt einen prinzipiellen Ablauf eines Verfahrens zur nichtlokalen Informationsübertragung mittels Quanten- oder Spininformation. Zunächst wird zumindest ein Paar bestehend aus einem ersten und einem zweiten quantenphysikalisch verschränkten Teilchen bereitgestellt. Typischerweise wird eine Vielzahl solcher Paare aus quantenphysikalisch verschränkten Teilchen bereitgestellt und eine statistische Messung durchgeführt.

Die Bereitstellung der verschränkten Teilchen 20, 20' erfolgt in den Unterschritten Erzeugen eines Primärstrahls 102 aus einer Teilchenquelle 100, z.B. einer Elektronenkanone 100. Richten des Primärstrahls 102 auf eine Streuvorrichtung 106 und Erzeugen der quantenphysikalisch verschränkten Teilchen 20, 20' in der Streuvorrichtung 106 durch Richten des Primärstrahls 102 auf die Streuvorrichtung 106 und Streuung des Primärstrahls 102 an Teilchen der Streuvorrichtung 106. Besonders bevorzugt besteht der Primärstrahl 102 aus den gleichen Teilchen wie diejenigen, an denen die Streuung in der Streuvorrichtung 106 geschieht. Mit anderen Worten handelt es sich bevorzugt um Teilchen derselben Teilchensorte, zum Beispiel Elektronen an Elektronen oder Protonen an Protonen.

Ferner erfolgt noch der Transport 22 der Teilchen 20, 20' zu einer Manipulationseinrichtung 50 zum Erfassen 62 der Quanten- oder Spininformation aus dem ersten und/oder zweiten verschränkten Teilchen 20, 20' mittels elektromagnetischer Wechselwirkung. In einem weiteren Schritt erfolgt das Speichern der Quanten- oder Spininformation des ersten und/oder zweiten verschränkten Teilchens 20, 20' in einem Informationsspeicher 60, z.B. einem Speichermedium 60.

Als folgender Schritt erfolgt der koinzidente Nachweis des zumindest einen Paares quantenphysikalisch verschränkter Teilchen mit Hilfe der Messvorrichtung 40. Hierbei kann die Abhängigkeit des Wirkungsquerschnitts bei symmetrischer Streuung von der Spinmessung nach der Streuung genutzt werden. Es ist daher bevorzugt, wenn mit der Messvorrichtung 40 die Intensität der gestreuten Teilchen nachgewiesen wird.

In einem weiteren Schritt erfolgt die Bestimmung einer Kenngröße der aus dem koinzidenten Nachweis erhaltbaren Koinzidenzrate aus der mit der Messvorrichtung 40 durchgeführten Messung. Die Bestimmung dieser Kenngröße erfolgt besonders bevorzugt zeitlich vor dem folgenden Schritt der Manipulation der gespeicherten Quanten- oder Spininformation des ersten und/oder zweiten verschränkten Teilchens 20, 20'.

In noch einem Schritt erfolgt eine Manipulation der gespeicherten Quanten- oder Spininformation des ersten und/oder zweiten verschränkten Teilchens 20, 20' in Abhängigkeit von der Koinzidenzrate. Mit anderen Worten kann nach Vorliegen der Koinzidenzrate, also dem Ergebnis der Messung mit der Messvorrichtung 40, die gespeicherte Quanten- oder Spininformation des ersten und/oder zweiten verschränkten Teilchens 20, 20' manipuliert werden oder nicht manipuliert werden. Die Manipulation der gespeicherten Quanten- oder Spininformation des ersten und/oder zweiten verschränkten Teilchens 20, 20' hat einen Einfluss auf die erhaltene Koinzidenzrate, die besonders bevorzugt zeitlich jedoch bereits vor der Manipulation der gespeicherten Quanten- oder Spininformation des ersten und/oder zweiten verschränkten Teilchens 20, 20' ausgewertet wurde.

Die elektromagnetische Strahlung wird in der Vorrichtung bevorzugt durch Begrenzungen so eingeschränkt, dass die Strahlung im Wesentlichen oder vollständig in der Vorrichtung verbleibt. Es wird also mit anderen Worten ein elektromagnetischer Resonator gebildet. Auf das Speichermedium kann die Quanten- oder Spininformation des ersten und/oder zweiten verschränkten Teilchens 20, 20' übertragen werden. Beispielsweise kann sich dadurch die Wahrscheinlichkeit der positiven Messung durch die Messvorrichtung 40 erhöhen, z.B. bis der maximale theoretische Gesamtwert erreicht ist. Bei einer nur kleinen Zahl an gleichzeitig angeregten Übergängen kann die elektromagnetische Strahlung, d.h. die Quanten- oder Spininformation des ersten und/oder zweiten verschränkten Teilchens 20, 20', direkt im elektromagnetischen Resonator 30 gespeichert werden um diese ggf. später auf das Speichermedium 60 zu übertragen.

Insbesondere durch Kopplung des Speichermediums 60 an ein geeignetes Wechselfeld, mittels welchem gespeicherte Spinübergänge unter Kopplung an einen Resonator an- oder abgeregt werden können, kann die Messung der Spinzustände mit dem Speichermedium 60 manipuliert werden. Das Anlegen des an einen Resonator gekoppelten Wechselfeldes, typischerweise ein Hochfrequenzfeld, führt daher bevorzugt zu einer nichtlokalen Änderung des Messsignals.

Durch den Austausch des Speichermediums, oder durch das Zerfallen des Spinzustands nach einer Zerfallszeit, oder durch ein Messen der Speicherinformation wird die Vorrichtung in einen Ausgangszustand wie vor Beginn der Informationsübertragung zurückgesetzt. Messen oder Zerfallen der Speicherinformation bedeutet dabei eine Übertragung der Spininformation auf andere Quantenzustände in einem Resonator mit niedriger Güte. Durch eine Wiederholung kann weitere Information übertragen und manipuliert werden. Hierbei kann also mit anderen Worten eine nichtlokale Änderung des Messsignals erreicht werden.

Um es mit anderen Worten zu sagen: Das Speichermedium 60 speichert zunächst die Information, ob das erste und zweite Streuteilchen 20, 20' unterscheidbar sind oder ununterscheidbar, also verschränkt, sind. Diese Information wird entweder mittels Elektronenübergang oder mittels Spinübertragung von dem Streuteilchen 20 an das Speichermedium 60 abgegeben. Nachdem das Messergebnis der Unterscheidbarkeit der Streuteilchen, also der Koinzidenzmessung mittels der Messeinrichtung 40, vorliegt, wird mittels der Manipulationseinrichtung 50 entweder die im Speichermedium 60 gespeicherte Information gelöscht oder behalten. Diese Manipulation der im Speichermedium 60 gespeicherten Information beeinflusst das Messergebnis der Koinzidenzmessung.

Aufgrund der derzeit realisierbaren Messgenauigkeiten wird hierbei auf die Messung von einer Vielzahl von Elektronen, beispielsweise 10⁵ Elektronenpaare oder mehr, zurückgegriffen und der Einfluss der Manipulationseinrichtung 50 auf die statistische Auswertung der Koinzidenzmessung beobachtet.

Der Resonator 30 beeinflusst die Speicherung der Quanten- oder Spininformation im Speichermedium 60. Der Resonator 30 kann als Schwingkreis aufgefasst werden, wobei der Resonator 30 eine von außen verstellbare Kapazität aufweist.

Wird die Vorrichtung zur Übertragung bzw. Manipulation einer Information beispielsweise mit angepasster Kapazität und/oder angepasstem ohmschen Widerstand des Schwingkreises betrieben, kann mittels der Anpassung die Güte des Resonators eingestellt werden. Soll also beispielsweise ein Resonator 30 hoher Güte bereitgestellt werden, so kann der im Schwingkreis eingesetzte ohmsche Widerstand mit einem kleinen Widerstandswert im Verhältnis zur der Impedanz bzw. dem Blindwiderstand der Kapazität eingesetzt werden. Es kann auch der Blindwiderstand der Kapazität entsprechend angepasst werden. Es lässt sich hierdurch die Resonanzfrequenz des Schwingkreises an die gewünschte Übergangsfrequenz anpassen, z.B. an eine zu erwartende Spin-Flip-Frequenz. Dies entspricht einer Messung mit Resonator 30 hoher Güte, d.h. mit einem Qualitätsfaktor Q > 1. Bevorzugt kann der Resonator 30 einen Qualitätsfaktor Q >> 1, weiter bevorzugt von Q > 3 oder weiter bevorzugt Q > 10 aufweisen. Bei Vorliegen eines Resonators hoher Güte wird die Quanten- oder Spininformation im Speichermedium 60 gelöscht. Als Resultat ist das Messergebnis der Koinzidenzmessung typisch niedrig.

Wird eine Messung der Quanten- oder Spininformation z.B. mit "nicht angepasster" Kapazität und/oder einem hohen ohmschen Widerstand im Verhältnis zu dem Blindwiderstand der Kapazität durchgeführt, entspricht dies einer Messung mit Resonator 30 niedriger Güte, d.h. mit einem Qualitätsfaktor Q < 1. Bevorzugt kann der Resonator 30 niedriger Güte einen Qualitätsfaktor Q < 1/5 aufweisen, weiter bevorzugt Q < 1/10. Hieraus resultierend zerfällt die Quanten- oder Spininformation im Speichermedium 60, was einer Messung der Quanten- oder Spininformation entspricht. Als Resultat ist das Messergebnis der Koinzidenzmessung typisch hoch.

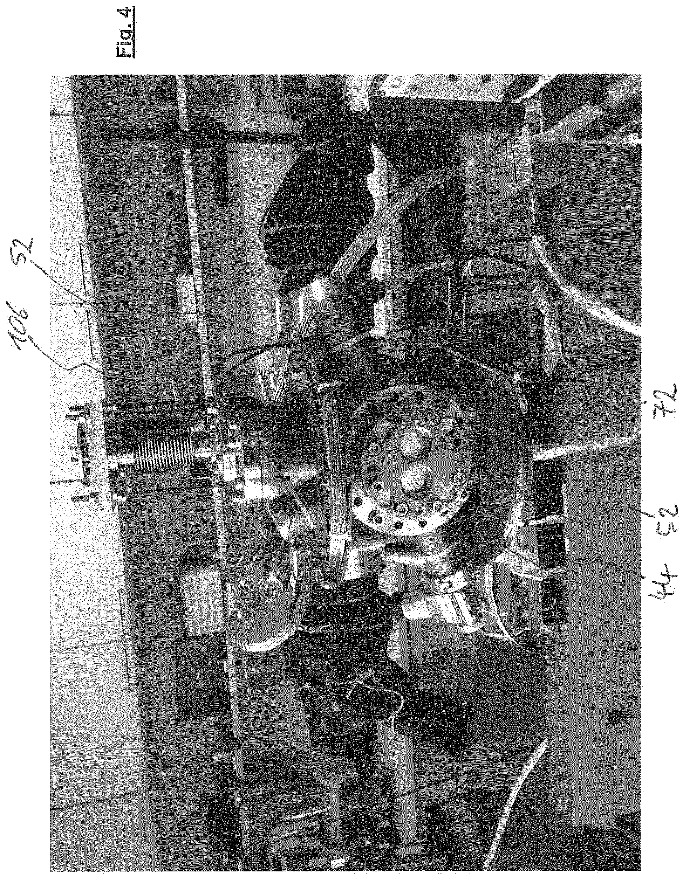

Fig. 4 zeigt eine mittige Draufsicht auf einen Endflansch 72 eines experimentellen Aufbaus, wobei zwei Szintillator-Scheiben 44 hinter jeweils einem Sichtfenster 46 angeordnet sind. Auf die Szintillatoren 44 werden bei einer Messung Photo-Counting-Heads aufgesetzt. Die Signale der Photo-Counting-Heads werden nach Verstärkung und Koinzidenzanalyse als Messsignal der verschränkten Teilchenpaare 20, 20' ausgewertet.

Oberhalb und unterhalb der Szintillatoren 44 sind außerhalb der Vakuumkammer horizontale Spulen 52 angebracht, die ein vertikales B-Feld erzeugen. Dieses statische B-Feld durchdringt die Vakuumkammer und ist auch im Speichermedium 60 vorhanden. Dort definiert dieses Feld dann -ggf. zusammen mit einem gleichzeitig vorhandenen Erdmagnetfeld und/oder anderen natürlichen oder künstlichen Feldern - die Quantenniveaus der Elektronenspins im Speichermedium 60.

Diverse sichtbare Kabelzuführungen versorgen eine HF-Spule im Speichermedium 60. Mittig ist ferner ein Wellbalg an einem XYZ-Tisch sichtbar, der zur Montage eines dünnen C-Targets 106 eingesetzt wird (Streuapparat).

Hinter dem Doppelkreuzstück ist die Elektronenkanone 100 (Teilchenquelle) angeordnet. Die seitlichen Flansche dienen zum Nachweis der Elektronen nach einer räumlichen Trennung. Hierdurch kann ebenfalls eine Koinzidenzanalyse erfolgen, ggf. ohne Durchgang der gestreuten Teilchen 20 durch ein Speichermedium 60.

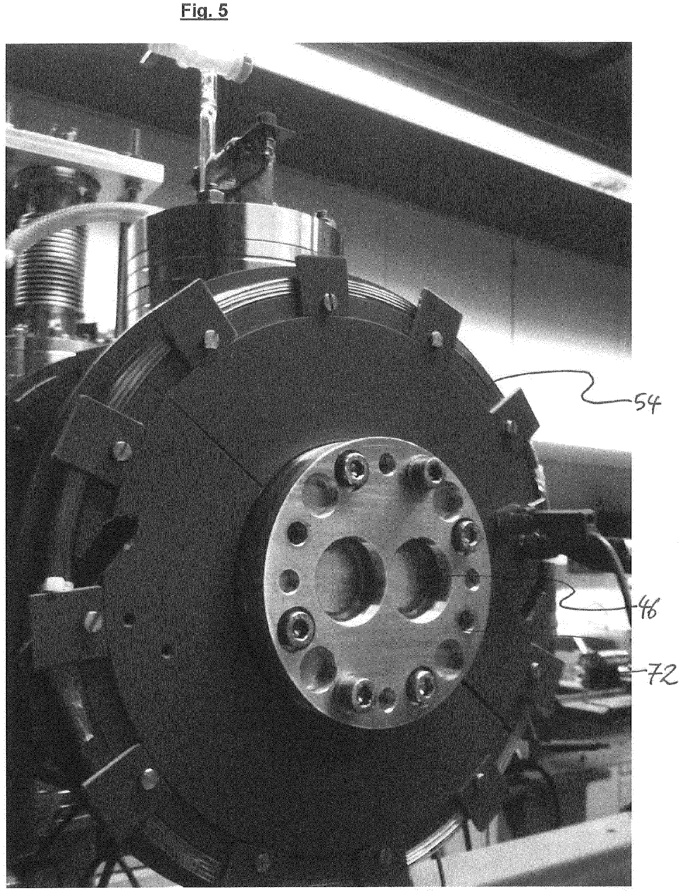

Fig. 5 zeigt eine weitere Ansicht eines experimentellen Aufbaus. Es ist ein Spulenpaar 54 zur Erzeugung eines axialen Magnetfeldes angebracht.

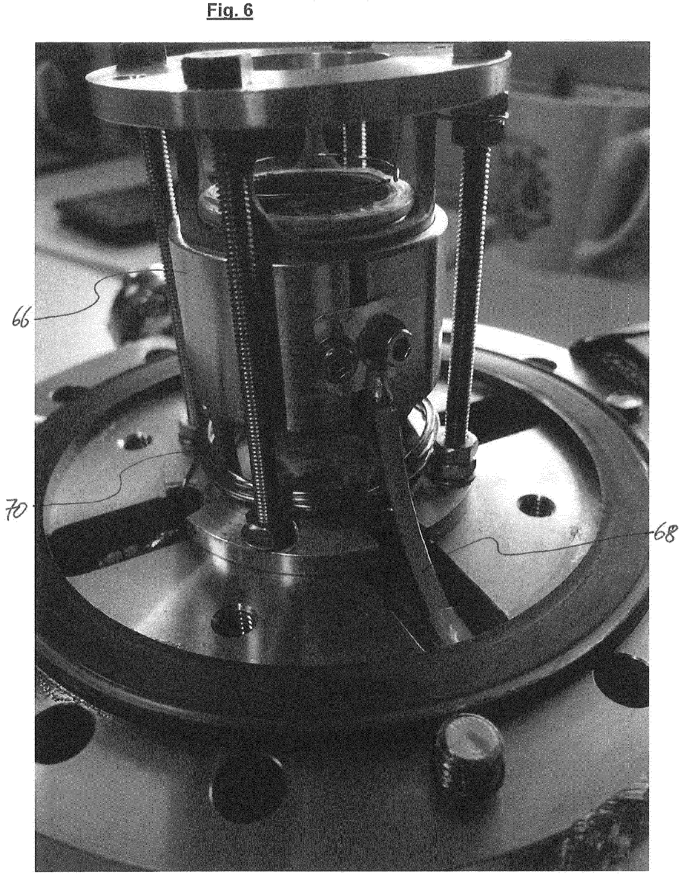

Fig. 6 zeigt einen weiteren experimentellen Aufbau eines Speichers bzw. Speichermediums 60. Fig. 6 zeigt eine geteilte Elektrode 66, die mit einem Hochspannungskabel 68 verbunden ist. Dieser Aufbau dient zusammen mit den Erdelektroden als Potentialfalle für gespeicherte Elektronen im zentralen Isolatormaterial. Die Elektronen können dabei aus früheren Streuprozessen oder aus einer zusätzlichen Elektronenquelle stammen. In der Mitte der zentralen Elektrode befindet sich ein Isolatormaterial mit mehrfachen Bohrungen parallel zur Achse. Unterhalb dieser Elektrodenanordnung ist eine HF-Spule 70 angebracht, mit der nach Verbindung mit einem äußeren HF-Generator die Spin-Flip-Übergänge der Elektronen angeregt werden können. Typisch wird dieser Aufbau noch einmal innerhalb eines Kupferrohres angebracht, das zur Abschirmung vor äußerer Störstrahlung eingesetzt wird. Das genannte Kupferrohr kann darüber hinaus gleichzeitig auch als Resonatorgehäuse dienen.

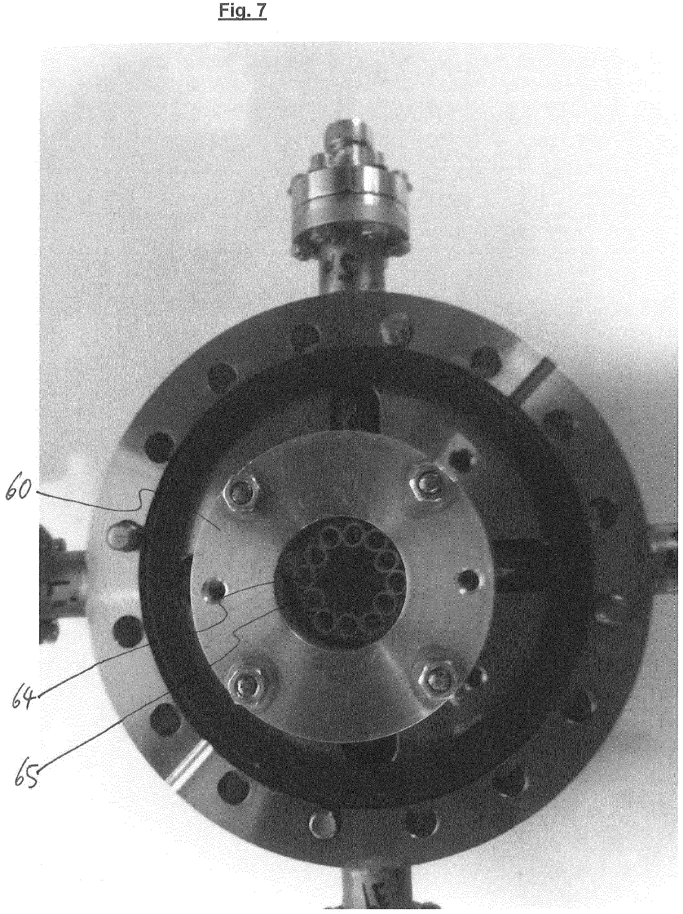

Fig. 7 zeigt einen weiteren Testaufbau eines Speichermediums 60. Die Darstellung blickt entlang der Strahlachse und zeigt PTFE- und Quarzröhrchen 65, die als Isolatormaterial 64 für die Elektronenspeicherung eingesetzt werden. Quarzglas 65 hat sich hierbei als gutes Isolatormaterial experimentell erwiesen. Auf die Isolatorröhrchen 65 des Isolatormaterials 64 werden bevorzugt Elektronen aufgesprüht, die hernach als freie Elektronen und somit als Speichermedium 60 bereitstehen.

Hinter diesen Röhrchen (in Strahlrichtung davor) ist dann typischerweise der Doppeldetektor aus zwei Szintillatorscheiben 44 angebracht.

Es ist dem Fachmann ersichtlich, dass die vorstehend beschriebenen Ausführungsformen beispielhaft zu verstehen sind. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind.

### Bezugszeichenliste:

- 20: Verschränkte Teilchen
- 22: Teilchentransport
- 30: Resonator
- 32: Linse
- 34: Ablenkfeld
- 40: Detektor bzw. Messvorrichtung
- 41: Goldfolie
- 42: weiterer Detektor
- 44: Szintillator
- 46: Sichtfenster
- 50: Manipulationseinrichtung
- 52: Spule
- 54: Spule
- 60: Speichermedium
- 62: Informationserfassung im Speichermedium
- 64: Isolatormaterial
- 65: PTFE- und Quarzröhrchen
- 66: Elektrode
- 68: Hochspannungskabel
- 70: HF-Spule
- 72: Endflansch
- 100: Elektronenkanone
- 102: Primärteilchen
- 104a: Primärstrahl-Magnet
- 104b: Primärstrahl-Magnet
- 106: Streutarget
- 108: Faraday-Cup

## Patentansprüche

1. Verfahren zur Informationsübertragung mittels Quanten- oder Spininformation, umfassend die Schritte:
Bereitstellen von zumindest einem Paar bestehend aus einem ersten und einem zweiten quantenphysikalisch verschränkten Teilchen (20, 20'),
Erfassen der Quanten- oder Spininformation aus dem ersten und/oder zweiten verschränkten Teilchen (20, 20') mittels elektromagnetischer Wechselwirkung,
Speichern der Quanten- oder Spininformation des ersten und/oder zweiten verschränkten Teilchens in einem Quanten- oder Spininformationsspeicher (60),
wobei durch das Speichern der Quanten- oder Spininformation ein Quantenzustand eines Speichermedium-Teilchens jedenfalls teilweise modifiziert wird,
koinzidentes Nachweisen des zumindest einen Paares quantenphysikalisch verschränkter Teilchen (20, 20'),
Festlegen einer Kenngröße, wobei die Kenngröße eine äußere Variable mit der Koinzidenz des zumindest einen Paares verschränkter Teilchen oder mit deren Koinzidenzrate in Verbindung setzt,
Manipulation der gespeicherten Quanten- oder Spininformation des ersten und/oder zweiten verschränkten Teilchens in Abhängigkeit von der Kenngröße.

2. Verfahren nach dem vorstehenden Anspruch, ferner mit dem Schritt Bestimmen einer Intensität oder einer Anzahl von verschränkten Teilchen.

3. Verfahren nach einem der Ansprüche 1 oder 2,
wobei die Kenngröße ein Schwellwert oder eine definierte wählbare Bedingung ist, und/oder
wobei die Kenngröße zwei verschiedene Zustände einnehmen kann, um auf die Manipulation der Spin- oder Quanteninformation einzuwirken.

4. Vorrichtung zur Übertragung und/oder Manipulation einer Information, die in einem System aus zumindest zwei quantenphysikalisch verschränkten Teilchen (20, 20') enthalten ist, umfassend
- eine Begrenzung (30) zur Einschränkung der Ausbreitung von elektromagnetischer Strahlung der Teilchen (20, 20'),
- eine Messeinrichtung (40, 40', 41, 41', 42, 42') zur Bestimmung einer Intensität oder einer Anzahl verschränkter Teilchen oder einer Koinzidenz,
- eine Erfassungseinrichtung zum Empfangen der Quanten- oder Spininformation aus zumindest einem der verschränkten Teilchen (20, 20') mittels elektromagnetischer Wechselwirkung,
- eine Manipulationseinrichtung (50) zur Manipulation der mit der Erfassungseinrichtung empfangenen Quanten- oder Spininformation;
- einen Quanten- oder Spininformationsspeicher (60) in der Erfassungseinrichtung zum Speichern der Quanten- oder Spininformation des ersten und/oder zweiten verschränkten Teilchens,
wobei durch das Speichern der Quanten- oder Spininformation ein Quantenzustand eines Speichermedium-Teilchens jedenfalls teilweise modifiziert wird,
wobei die Manipulationseinrichtung (50) dazu eingerichtet ist, die gespeicherte Quanten- oder Spininformation des ersten und/oder zweiten verschränkten Teilchens in Abhängigkeit von einer Kenngröße zu manipulieren, wobei die Kenngröße eine äußere Variable mit der Koinzidenz des zumindest einen Paares verschränkter Teilchen oder mit deren Koinzidenzrate in Verbindung setzt.

5. Vorrichtung nach dem vorstehenden Anspruch,
wobei die Manipulationseinrichtung (50) dazu hergerichtet ist, die Manipulation der Spininformation durch eine selektive Anregung der betroffenen Quantenzustände durchzuführen oder
wobei die Manipulationseinrichtung (50) dazu hergerichtet ist, die Manipulation der Spininformation durch ein wählbares Messen von orthogonalen Quantenzuständen der Spininformation durchzuführen.

6. Vorrichtung nach einem der Ansprüche 4 oder 5,
wobei eine anteilige Bestimmung der Verschränkung der Teilchen (20, 20') zusammen mit einer Übertragung von Spininformation von einigen der verschränkten Teilchen auf das Speichermedium (60) durchgeführt wird; und/oder
**gekennzeichnet dadurch, dass** der Quanten- oder Spininformationsspeicher (60) und/oder ein Träger des Quanten- oder Spininformationsspeichers zumindest zeitweise oder teilweise als ein Isolator, eine Flüssigkeit, als ein Gas oder als Plasma vorliegt

7. Vorrichtung nach einem der Ansprüche 4 bis 6, **dadurch gekennzeichnet, dass** die wahlweise Manipulation der gespeicherten Spininformation an einem anderen Ort erfolgt als die Übertragung von Spininformation von den verschränkten Teilchen (20, 20');
und/oder
dass die Erfassungseinrichtung Mittel aufweist zum Bereitstellen eines elektrischen oder magnetischen Felds für die Übertragung der Spininformation.

8. Vorrichtung nach einem der Ansprüche 4 bis 7, **dadurch gekennzeichnet, dass** die Teilchen (20, 20') eine Ladung und einen Spin aufweisen, wobei die Teilchen verschränkte Elektronen, Protonen, Deuteronen, Tritonen, Wasserstoffatome, Wasserstoffmoleküle, 3He-Ionen oder 3He-Atome umfassen.

9. Vorrichtung nach einem der Ansprüche 4 bis 8, **dadurch gekennzeichnet, dass** Elektronen, Ionen, Atome oder Moleküle als Speichermedium-Teilchen verwendet werden, indem bei ihnen direkt oder indirekt, ganz oder teilweise mindestens ein Quantenzustand geändert wird und/oder
wobei die Quanten- oder Spininformation mittels elektromagnetischer Wechselwirkung auf die Speichermedium-Teilchen übertragbar ist.

10. Vorrichtung nach einem der Ansprüche 4 bis 9,
ferner mit:
- einer Strahlungsquelle (100) zum Erzeugen von Primärteilchen (102),
- einem Streutarget (106),
wobei die Strahlungsquelle (100) auf das Streutarget (106) gerichtet ist zum Beschicken des Streutargets (106) mit den Primärteilchen (102) zur Erzeugung von verschränkten Teilchen (20, 20') durch eine Wechselwirkung der Primärteilchen (102) mit dem Streutarget (106); und/oder
ferner mit:
- einer Transportstrecke zum Transport (22) der verschränkten Teilchen (20, 20') zu einem Endflansch (72),
- zwei an dem Endflansch (72) angeordnete Szintillatoren (44) zur Erzeugung eines Messsignals zur Auswertung der verschränkten Teilchen; und/oder
ferner mit einer Potentialfalle für gespeicherte Teilchen.

11. Vorrichtung nach einem der Ansprüche 4 bis 10, ferner mit einer Anregungseinrichtung, zur Festlegung der Quantenniveaus im Quanten- oder Spininformationsspeicher (60).

12. Vorrichtung nach einem der Ansprüche 4 bis 11,
wobei eine Kenngröße festgelegt ist, wobei die Kenngröße eine äußere Variable mit der Koinzidenz des zumindest einen Paares verschränkter Teilchen oder mit deren Koinzidenzrate in Verbindung setzt,
wobei die Kenngröße ein Schwellwert, eine definierte wählbare Bedingung oder die Koinzidenzrate ist, und/oder
wobei die Kenngröße zwei verschiedene Zustände einnehmen kann, um auf die Manipulation der Spin- oder Quanteninformation einzuwirken.

13. Vorrichtung nach einem der Ansprüche 4 bis 12, wobei die Speichermedium-Teilchen für eine makroskopische Zeitspanne in einem definierbaren Zustand aufbewahrt werden, wobei die makroskopische Zeitspanne größer ist als 1 Mikrosekunde.

14. Quantencomputer mit einer Vorrichtung nach einem der Ansprüche 4 bis 13 zur Manipulation und Speicherung von Quantenbitzuständen.

15. System zur Informationsübertragung in die Vergangenheit, umfassend eine Vorrichtung gemäß einem der Ansprüche 4 bis 13 zur Übertragung und/oder Manipulation einer Information, die in einem System aus zumindest zwei quantenphysikalisch verschränkten Teilchen (20, 20') enthalten ist,
wobei die in den quantenphysikalisch verschränkten Teilchen enthaltene Information rückwirkend durch die Manipulation der empfangenen Spininformation festgelegt wird und wobei hierdurch eine Information in die Vergangenheit übertragen wird.

## Claims

1. A method for transmitting information by means of quantum or spin information, comprising the steps of:
providing at least one pair consisting of a first and a second quantum-mechanically entangled particle (20, 20');
detecting the quantum or spin information from the first and/or second entangled particle (20, 20') via electromagnetic interaction;
storing the quantum or spin information of the first and/or second entangled particle in a quantum or spin information storage (60);
wherein the storing of the quantum or spin information at least partially modifies a quantum state of a storage medium particle;
coincident detection of the at least one pair of quantum-mechanically entangled particles (20, 20');
defining a characteristic variable, said characteristic variable linking an external variable with the coincidence of the at least one pair of entangled particles or with their coincidence rate;
manipulating the stored quantum or spin information of the first and/or second entangled particle as a function of the characteristic variable.

2. The method according to the preceding claim, further comprising the step of determining an intensity or a number of entangled particles.

3. The method according to any one of claims 1 or 2,
wherein the characteristic variable is a threshold value or a defined selectable condition; and/or
wherein the characteristic variable can assume two different states in order to influence the manipulation of the spin or quantum information.

4. An apparatus for transmitting and/or manipulating information contained in a system comprising at least two quantum-mechanically entangled particles (20, 20'), comprising
- a confinement structure (30) for restricting the propagation of electromagnetic radiation of the particles (20, 20');
- a measuring device (40, 40', 41, 41', 42,42') for determining an intensity or a number of entangled particles or a coincidence;
- a detection device for receiving the quantum or spin information from at least one of the entangled particles (20, 20') via electromagnetic interaction;
- a manipulation device (50) for manipulating the quantum or spin information received by the detection device;
- a quantum or spin information storage (60) within the detection device for storing the quantum or spin information of the first and/or second entangled particle;
wherein the storing of the quantum or spin information at least partially modifies a quantum state of a storage medium particle;
wherein the manipulation device (50) is configured to manipulate the stored quantum or spin information of the first and/or second entangled particle as a function of a characteristic variable, said characteristic variable linking an external variable with the coincidence of the at least one pair of entangled particles or with the coincidence rate thereof.

5. The apparatus according to the preceding claim,
wherein the manipulation device (50) is configured to perform the manipulation of the spin information by selectively exciting the relevant quantum states; or
wherein the manipulation device (50) is configured to manipulate the spin information by selectively measuring orthogonal quantum states of the spin information.

6. The apparatus according to any one of claims 4 or 5,
wherein a partial determination of the entanglement of the particles (20, 20') is performed together with a transfer of spin information from some of the entangled particles to the storage medium (60); and/or
**characterised in that** the quantum or spin information storage (60) and/or a support medium of the quantum or spin information storage is at least temporarily or partially present as an insulator, a liquid, a gas, or a plasma.

7. The apparatus according to any one of claims 4 to 6, **characterised in that**
the selective manipulation of the stored spin information is performed at a location different from that at which spin information is transmitted from the entangled particles (20, 20'); and/or
that the detection device comprises means for providing an electric or magnetic field for the transmission of the spin information.

8. The apparatus according to any one of claims 4 to 7, **characterised in that** the particles (20, 20') have a charge and a spin, said particles comprising entangled electrons, protons, deuterons, tritons, hydrogen atoms, hydrogen molecules, ³He ions or ³He atoms.

9. The apparatus according to any one of claims 4 to 8, **characterised in that** electrons, ions, atoms or molecules are used as storage medium particles, **in that** at least one quantum state thereof is changed directly or indirectly, in whole or in part; and/or wherein the quantum or spin information is transferable to the storage medium particles via electromagnetic interaction.

10. The apparatus according to any one of claims 4 to 9,
further comprising:
- a radiation source (100) for generating primary particles (102),
- a scattering target (106),
wherein the radiation source (100) is directed at the scattering target (106) for supplying the scattering target (106) with primary particles (102) to generate entangled particles (20, 20') by interaction of the primary particles (102) with the scattering target (106); and/or
further comprising:
- a transport line for transporting (22) the entangled particles (20, 20') to an end flange (72);
- two scintillators (44) arranged at the end flange (72) for generating a measurement signal for evaluating the entangled particles; and/or
further comprising a potential trap for stored particles.

11. The apparatus according to any one of claims 4 to 10, further comprising an excitation device for defining the quantum levels in the quantum or spin information storage (60).

12. The apparatus according to any one of claims 4 to 11,
wherein a characteristic variable is defined, said characteristic variable linking an external variable with the coincidence of the at least one pair of entangled particles or with the coincidence rate thereof;
wherein the characteristic variable is a threshold value, a defined selectable condition, or the coincidence rate; and/or
wherein the characteristic variable can assume two different states in order to influence the manipulation of the spin or quantum information.

13. The apparatus according to any one of claims 4 to 12, wherein the storage medium particles are kept in a definable state for a macroscopic time span, said macroscopic time span being greater than 1 microsecond.

14. A quantum computer comprising an apparatus according to any one of claims 4 to 13 for manipulating and storing quantum bit states.

15. A system for transmitting information into the past, comprising an apparatus according to any one of claims 4 to 13 for transmitting and/or manipulating information contained in a system comprising at least two quantum-mechanically entangled particles (20, 20'),
wherein the information contained in the quantum-mechanically entangled particles is defined retroactively by the manipulation of the received spin information, and wherein information is thereby transmitted into the past.

## Revendications

1. Procédé de transmission d'informations au moyen d'informations quantiques ou de spin, comprenant les étapes suivantes:
mise à disposition d'au moins une paire constituée d'une première particule et d'une deuxième particule intriquées quantiquement (20, 20'),
détection de l'information quantique ou de spin à partir de la première et/ou de la deuxième particule intriquée (20, 20') au moyen d'une interaction électromagnétique,
stockage de l'information quantique ou de spin de la première et/ou de la deuxième particule intriquée dans une mémoire d'informations quantiques ou de spin (60),
le stockage de l'information quantique ou de spin entraînant une modification, au moins partielle, d'un état quantique d'une particule du support de stockage,
détection en coïncidence de ladite au moins une paire de particules intriquées quantiquement (20, 20'),
définition d'un paramètre caractéristique, ledit paramètre caractéristique mettant en relation une variable externe avec la coïncidence de ladite au moins une paire de particules intriquées ou avec leur taux de coïncidence,
manipulation de l'information quantique ou de spin stockée de la première et/ou de la deuxième particule intriquée en fonction du paramètre caractéristique.

2. Procédé selon la revendication précédente, comprenant en outre l'étape de détermination d'une intensité ou d'un nombre de particules intriquées.

3. Procédé selon l'une quelconque des revendications 1 ou 2,
dans lequel le paramètre caractéristique est une valeur seuil ou une condition sélectionnable définie, et/ou
dans lequel le paramètre caractéristique peut prendre deux états différents afin d'influencer la manipulation de l'information de spin ou quantiques.

4. Dispositif pour la transmission et/ou la manipulation d'une information contenue dans un système comprenant au moins deux particules intriquées quantiquement (20, 20'), comprenant:
- une structure de confinement (30) pour restreindre la propagation du rayonnement électromagnétique desdites particules (20, 20'),
- un dispositif de mesure (40, 40', 41, 41', 42,42') pour déterminer une intensité ou un nombre de particules intriquées ou une coïncidence,
- un dispositif de détection pour recevoir l' information quantique ou de spin à partir d'au moins une desdites particules intriquées (20, 20') au moyen d'une interaction électromagnétique,
- un dispositif de manipulation (50) pour manipuler l'information quantique ou de spin reçue par le dispositif de détection,
- une mémoire d'informations quantiques ou de spin (60) dans le dispositif de détection, pour stocker l'information quantique ou de spin de la première et/ou de la deuxième particule intriquée,
le stockage de l'information quantique ou de spin entraînant une modification, au moins partielle, d'un état quantique d'une particule du support de stockage,
le dispositif de manipulation (50) étant configuré pour manipuler l'information quantique ou de spin stockée de la première et/ou deuxième particule intriquée en fonction d'un paramètre caractéristique, ledit paramètre caractéristique mettant en relation une variable externe avec la coïncidence de ladite au moins une paire de particules intriquées ou avec leur taux de coïncidence.

5. Dispositif selon la revendication précédente,
dans lequel le dispositif de manipulation (50) est configuré pour effectuer la manipulation de l'information de spin par une excitation sélective des états quantiques concernés ou
dans lequel le dispositif de manipulation (50) est configuré pour effectuer la manipulation de l'information de spin par une mesure sélectionnable d'états quantiques orthogonaux de ladite information de spin.

6. Dispositif selon l'une quelconque des revendications 4 ou 5,
dans lequel une détermination partielle de l'intrication des particules (20, 20') est effectuée conjointement avec un transfert d'information de spin de certaines des particules intriquées vers le support de stockage (60), et/ou
**caractérisé en ce que** la mémoire d'informations quantiques ou de spin (60) et/ou un support de ladite mémoire d'informations quantiques ou de spin se présente, au moins temporairement ou partiellement, sous la forme d'un isolant, d'un liquide, d'un gaz ou d'un plasma.

7. Dispositif selon l'une quelconque des revendications 4 à 6, **caractérisé en ce que** la manipulation sélective de l'information de spin stockée est effectuée en un autre endroit que celui où est effectuée le transfert d'informations de spin à partir des particules intriquées (20, 20'), et/ou
**en ce que** le dispositif de détection comprend des moyens pour fournir un champ électrique ou magnétique pour le transfert de l'information de spin.

8. Dispositif selon l'une quelconque des revendications 4 à 7, **caractérisé en ce que** les particules (20, 20') présentent une charge et un spin, lesdites particules intriquées comprenant des électrons, des protons, des deutérons, des tritons, des atomes d'hydrogène, des molécules d'hydrogène, des ions ³He ou des atomes de ³He.

9. Dispositif selon l'une quelconque des revendications 4 à 8, **caractérisé en ce que** des électrons, des ions, des atomes ou des molécules sont utilisés comme particules du support de stockage, **en ce qu'**au moins un état quantique est modifié chez ceux-ci, directement ou indirectement, en tout ou en partie, et/ou
**en ce que** l'information quantique ou de spin est transférable vers les particules du support de stockage au moyen d'une interaction électromagnétique.

10. Dispositif selon l'une quelconque des revendications 4 à 9,
comprenant en outre:
- une source de rayonnement (100) pour générer des particules primaires (102),
- une cible de diffusion (106),
la source de rayonnement (100) étant dirigée vers la cible de diffusion (106) afin d'alimenter ladite cible de diffusion (106) en particules primaires (102) afin de générer des particules intriquées (20, 20') par interaction des particules primaires (102) avec la cible de diffusion (106), et/ou
comprenant en outre:
- une ligne de transport destinée au transport (22) des particules intriquées (20, 20') vers une bride d'extrémité (72),
- deux scintillateurs (44) disposés sur ladite bride d'extrémité (72) pour générer un signal de mesure pour l'évaluation des particules intriquées, et/ou
comprenant en outre un piège à potentiel pour des particules stockées.

11. Dispositif selon l'une quelconque des revendications 4 à 10, comprenant en outre un dispositif d'excitation pour définir les niveaux quantiques dans le stockage d'informations quantiques ou de spin (60).

12. Dispositif selon l'une quelconque des revendications 4 à 11,
dans lequel une paramètre caractéristique est définie, ledit paramètre caractéristique mettant en relation une variable externe avec la coïncidence d'au moins une paire de particules intriquées ou avec leur taux de coïncidence,
dans lequel ledit paramètre caractéristique est une valeur seuil, une condition sélectionnable définie ou le taux de coïncidence, et/ou
dans lequel ledit paramètre caractéristique peut prendre deux états différents afin d'influencer la manipulation de l'information de spin ou quantiques.

13. Dispositif selon l'une quelconque des revendications 4 à 12, dans lequel les particules du support de stockage sont conservées dans un état définissable pendant une durée macroscopique, la durée macroscopique étant supérieure à 1 microseconde.

14. Ordinateur quantique comprenant un dispositif selon l'une quelconque des revendications 4 à 13 pour la manipulation et le stockage d'états de qubits.

15. Système pour la transmission d'informations dans le passé, comprenant un dispositif selon l'une quelconque des revendications 4 à 13 pour la transmission et/ou la manipulation d'une information contenue dans un système comprenant au moins deux particules intriquées quantiquement (20, 20'),
dans lequel l'information contenue dans les particules intriquées quantiquement est déterminée rétroactivement par la manipulation de l'information de spin reçues, et dans lequel une information est ainsi transmise dans le passé.
